Europäisches Patentamt

European Patent Office

Office européen des brevets

(11) Numéro de publication: **0 403 368**
**A1**

## (12) DEMANDE DE BREVET EUROPEEN

(21) Numéro de dépôt: 90401622.7

(22) Date de dépôt: 12.06.90

(51) Int. Cl.5: **H01L 21/336, H01L 21/28, H01L 21/82, H01L 29/784**

(30) Priorité: 14.06.89 FR 8907878

(43) Date de publication de la demande:
19.12.90 Bulletin 90/51

(84) Etats contractants désignés:
CH DE ES FR GB IT LI NL

(71) Demandeur: COMMISSARIAT A L'ENERGIE ATOMIQUE Etablissement de Caractère Scientifique Technique et Industriel
31/33, rue de la Fédération
F-75015 Paris(FR)

(72) Inventeur: Hartmann, Joel
13, rue de la Balmette
F-38640 Claix(FR)

(74) Mandataire: Mongrédien, André et al
c/o BREVATOME 25, rue de Ponthieu
F-75008 Paris(FR)

(54) Procédé de fabrication d'un circuit integré comportant un transistor à effet de champ à double implantation.

(57) Après formation de l'oxyde de champ (54) dans un substrat (52) en silicium, de l'oxyde de grille (56) et de la grille (58a) en silicium polycristallin du transistor, on effectue une oxydation thermique (59) de la structure puis le dépôt d'une couche protectrice (62) en silicium ; on forme ensuite des espaceurs (66) isolants sur les flancs de la grille et un masque (68) de photolithographie pourvu d'une ouverture (69) à l'emplacement prévu pour le transistor ; on effectue une première implantation ionique (70) pour former les source et drain (72, 74) ; on élimine les espaceurs ; on effectue une seconde implantation ionique (76) pour former les doubles jonctions (78, 80) ; enfin, on élimine le masque puis la couche protectrice.

FIG. 2 e

FIG. 2 f

# PROCEDE DE FABRICATION D'UN CIRCUIT INTEGRE COMPORTANT UN TRANSISTOR A EFFET DE CHAMP A DOUBLE IMPLANTATION

La présente invention a pour objet un procédé de fabrication d'un circuit intégré comportant au moins un transistor à effet de champ à double implantation. Elle s'applique en particulier dans le domaine des circuits intégrés de type nMOS, pMOS, CMOS et BICMOS et plus spécialement aux circuits intégrés dont les dimensions des grilles des transistors sont inférieures à 2 micromètres. Ces circuits sont en particulier des microprocesseurs, des microcontrôleurs, des mémoires, des circuits d'application spécifique (ASIC).

Avec la réduction des dimensions critiques des circuits intégrés, et plus particulièrement de la longueur de la grille des transistors MOS, les technologues ont été amenés à modifier le procédé de réalisation des source et drain de ces transistors.

En effet, plus la dimension de la grille est petite, plus la diffusion latérale de l'implantation source-drain sous la grille devient importante, et donc gênante, et plus le transistor MOS est sensible au phénomène de perçage entre la source et le drain, correspondant au courant de fuite entre la source et le drain pour une tension de grille nulle. Enfin, la diminution de cette longueur de grille entraîne un vieillissement prématuré du transistor MOS par injection de porteurs chauds dans l'oxyde de grille. Ce phénomène est d'autant plus important que la concentration de dopants au bord de la grille du transistor est élevée.

Pour toutes ces raisons, les transistors de type n et aussi de type p sont maintenant réalisés avec un procédé à double implantation appelé LDD (Low Doped Drain en terminologie anglo-saxonne) qui permet pour les technologies dont la dimension de grille est typiquement inférieure à 2 micromètres de résoudre les problèmes mentionnés ci-dessus.

Ce procédé devient absolument indispensable et primordial dans les technologies submicroniques.

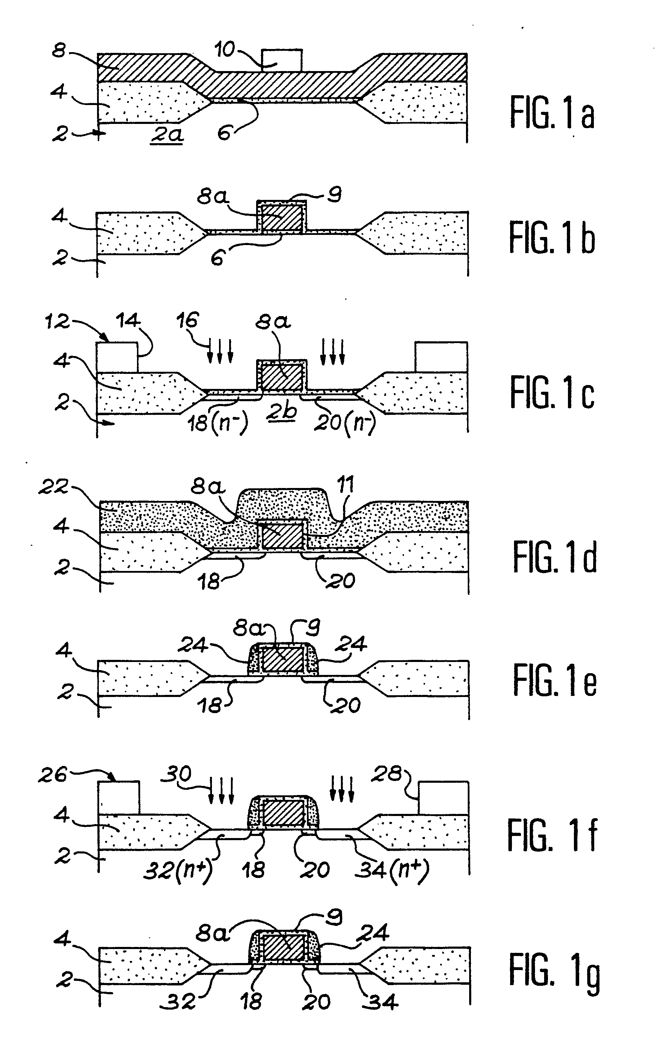

Sur les figures 1a-1g, on a représenté schématiquement, en coupe longitudinale, les différentes étapes du procédé communément utilisé aujourd'hui pour fabriquer un circuit intégré nMOS comportant un transistor à effet de champ à double implantation.

Ce procédé connu consiste, en référence à la figure 1a, à former sur un substrat en silicium 2 de type p, l'oxyde de champ 4 du circuit intégré par oxydation locale des régions 2a du substrat 2 (technique LOCOS) puis à former, aussi par oxydation thermique, une mince couche d'oxyde de grille 6. L'oxyde de champ 4 présente une épaisseur d'environ 600 nm et l'oxyde de grille une épaisseur d'environ 25 nm.

L'étape suivante consiste à déposer une couche conductrice de silicium polycristallin 8 dopé de 400 nm d'épaisseur par la technique de dépôt chimique en phase vapeur (CVD).

On réalise ensuite par photolithographie un premier masque de résine 10 destiné à masquer la région de la couche de silicium 8 dans laquelle la grille du transistor doit être réalisée, au-dessus de l'oxyde de grille 6.

On élimine alors les régions de la couche de silicium 8 non recouvertes de résine afin de former, comme représenté sur la figure 1b, la grille 8a du transistor. Ceci peut être réalisé par une attaque chimique, par une gravure ionique réactive ou tout autre type de gravure sèche.

Après élimination du masque de résine 10, on réalise généralement une oxydation thermique de la structure entraînant simultanément une oxydation 9 de la grille 8a du transistor en silicium polycristallin et une réoxydation des régions de source et drain de part et d'autre de la grille. Cette oxydation thermique, dénommée réoxydation, est réalisée à une température de l'ordre de 950° C.

On réalise ensuite, comme représenté sur la figure 1c, un second masque de résine 12 par photolithographie sur la structure obtenue, servant à définir l'emplacement de la source et du drain du transistor nMOS, en protégeant la partie du circuit intégré ne comportant pas de transistor nMOS. En particulier, ce masque 12 présente une ouverture 14 en regard de la région 2b du substrat dans laquelle doit être réalisé le transistor. Ce masque présente une épaisseur de 1,2 à 1,5 micromètres environ. Ce masque ne présente un intérêt que lorsque le circuit intégré comprend d'autres composants que des transistors nMOS.

On effectue ensuite une implantation 16 d'ions de type n, à faible dose, notamment de phosphore avec une énergie de 60keV et une dose de $10^{13}$ions/cm², afin de former, à l'aplomb de la grille 8a et dans le substrat semi-conducteur 2, deux régions 18 et 20 de type n⁻, correspondant respectivement à la source et au drain du transistor. La couche de résine 12, l'oxyde de champ 4 ainsi que la grille 8a revêtue de l'isolant électrique 9 servent de masque à cette implantation ionique.

Cette implantation à faible dose permet de diminuer considérablement la concentration de dopants à l'aplomb de la grille du transistor et donc de résoudre les problèmes électriques mentionnés ci-dessus.

Cependant, cette implantation ne suffit pas à elle seule pour remplir le rôle de source et de drain du transistor car la résistance de la source et du drain est trop importante. Une implantation de type $n^+$ (forte dose) est toujours nécessaire, mais il faut l'écarter physiquement du bord de grille pour qu'elle ne se superpose pas à la zone $n^-$. Ceci conduit donc à la fabrication d'espaceurs ou bandes d'espacement.

Aussi, après l'implantation à faible dose et l'élimination du masque de résine 12, on dépose généralement sur l'ensemble de la structure, comme représenté sur la figure 1d, une couche d'oxyde de silicium 22 de 500 nm environ d'épaisseur. Cette couche d'oxyde est déposée de façon isotrope, notamment par la technique de dépôt chimique en phase vapeur, assistée ou non par plasma ; ce dépôt isotrope permet d'obtenir une même épaisseur d'oxyde sur les flancs 11 et sur le dessus de la grille 8a.

On effectue ensuite une gravure "pleine plaque" de la couche 22 (c'est-à-dire sans masque) afin de former sur les flancs isolés 11 de la grille 8a des espaceurs ou liserés d'oxyde 24, comme représenté sur la figure 1e, cette gravure entraînant aussi la consommation (50 à 100 nm environ) de l'oxyde de champ. Cette gravure est réalisée par une technique de gravure anisotropique (gravure ionique réactive, gravure par plasma ou tout autre type de gravure sèche anisotropique). Les espaceurs 24 présentent une largeur à la base d'environ 200 à 300 nm et sont destinés à repousser l'implantation forte dose des bords de la grille.

On forme ensuite comme représenté sur la figure 1f, un troisième masque de résine 26 identique au second masque de résine 12, par photolithographie, dans le cas d'un circuit intégré comportant d'autres composants que des transistors nMOS. En particulier, ce masque 26 comporte une ouverture 28 située au-dessus de la région du substrat 2b dans laquelle on réalise le transistor nMOS.

On effectue alors une implantation 30 de type n à forte dose, par exemple d'arsenic à une dose de $5 \times 10^{15}$ ions/cm² et une énergie de 100keV, afin de former respectivement sous la source 18 et le drain 20 du transistor deux régions respectivement 32 et 34 de type $n^+$. Ces deux régions 32 et 34 constituent les secondes jonctions du transistor.

Après élimination du masque de résine 26 (figure 1g), on effectue un recuit de la structure obtenue pour guérir les défauts introduits lors des implantations.

Les étapes suivantes du procédé, non représentées, sont identiques à celles utilisées en technologie MOS sans LDD. Elles consistent notamment à déposer une couche d'isolant, par exemple d'oxyde de silicium sur l'ensemble de la structure, à former dans celle-ci des trous de contact électrique, et à déposer une couche conductrice par exemple en aluminium que l'on grave afin de former les différentes connexions du transistor.

Par exemple en technologie CMOS, utilisant des transistors nMOS et des transistors pMOS intégrés sur un même substrat, le second masque de lithographie 12 sert en particulier à protéger tous les transistors pMOS de l'implantation de type n à faible dose. De même, le troisième masque de résine 26 sert à protéger en particulier tous les transistors pMOS de l'implantation de type n à forte dose.

La fabrication des transistors pMOS est similaire à celle des transistors nMOS. En technologie CMOS, elle consiste à former, par exemple juste après l'implantation $n^-$, un masque photolithographique définissant l'emplacement de ces transistors pMOS et masquant en particulier l'emplacement des transistors nMOS à réaliser et à implanter, à travers ce masque, des ions de type p à faible dose (par exemple des ions de bore à une énergie de 40keV et une dose de $2 \times 10^{13}$ ions/cm²). Après élimination de ce masque d'implantation, on procède à la fabrication des espaceurs.

L'implantation à forte dose des transistors pMOS est réalisée après l'implantation de type n à forte dose et juste après la formation d'un autre masque photolithographique identique au précédent masque d'implantation des ions de type p. Elle est effectuée en implantant par exemple des ions de $BF_2$ à une énergie de 40keV et une dose de $4 \times 10^{15}$ ions/cm².

Ce procédé connu présente l'inconvénient d'être relativement complexe. En particulier, il comprend plusieurs étapes de masquage (10, 12, 26). Par exemple, on voit qu'en technologie CMOS utilisant des transistors LDD, il faut quatre masques d'implantation pour la réalisation des jonctions de source et drain de ces transistors alors qu'il n'en faut que deux pour une technologie CMOS sans LDD. Ces étapes de masquage sont relativement longues (dépôt d'une couche de résine, insolation à travers un photo-masque, développement). Elles sont inévitablement source de réduction des performances des circuits, notamment par l'introduction de particules supplémentaires.

La complexité de ce procédé augmente donc les risques de mauvaise fabrication et donc de circuits intégrés de mauvaise qualité électrique ainsi que le coût de ces circuits. Aussi, tout procédé permettant de réduire le nombre de niveaux de masquage est très précieux. En outre, ce procédé conduit à une consomma tion de l'oxyde de champ lors de la gravure de la couche d'oxyde pour former les espaceurs, modifiant les propriétés électriques de l'oxyde de champ et pouvant favoriser la création de transistors parasites dans les isolations latérales.

Un procédé permettant de réduire le nombre d'opérations de masquage pour une technologie NMOS ou CMOS avec des transistors LDD est en particulier décrit dans le document US-A-4 753 898. Ce procédé se distingue du précédent en ce que l'on forme les espaceurs avant toute implantation ionique des source et drain des transistors, on inverse l'ordre des deux implantations, l'implantation à forte dose étant effectuée avant l'implantation à faible dose, en utilisant le même masque de résine, et on élimine les espaceurs entre les deux implantations.

Afin d'enlever ces espaceurs sans affecter la structure sous-jacente, ces derniers sont réalisés en silicium polycristallin. Malheureusement, dans la mesure où il faut un dépôt d'une épaisseur de 400 nm environ de silicium polycristallin pour réaliser les espaceurs, il faut réoxyder la grille et les jonctions du transistor de manière importante. En effet, la réoxydation de la grille et des jonctions du transistor doit tenir compte de la sélectivité de gravure du silicium polycristallin sur $SiO_2$ lorsque l'on grave de manière anisotrope la couche de silicium polycristallin de 400 nm, puis une fois encore de cette sélectivité de gravure lorsque l'on élimine de manière isotrope les espaceurs en silicium polycristallin.

Comme généralement cette sélectivité est rarement supérieure à 10/1, on voit que l'épaisseur de réoxydation de la grille du transistor de 30 nm proposée dans le brevet américain ci-dessus est nettement insuffisante car elle conduit à une réoxydation d'environ 10 nm sur les zones actives (source-drain) sur silicium.

Il faut donc viser, d'après l'inventeur, une réoxydation sur zones actives d'environ 30 nm, ce qui conduit à une réoxydation d'environ 80 nm sur la grille en silicium polycristallin du transistor.

Comme les transistors à double implantation sont utilisés et rendus nécessaires dans les technologies submicroniques (500 à 1000 nm de longueur de grille), on s'aperçoit qu'une telle réoxydation est très limitative, car elle augmente de façon sensible le "budget" thermique des implantations ioniques de canal effectuées auparavant dans l'assemblage technologique : ce qui a pour conséquence de dégrader fortement le fonctionnement de ces transistors.

En effet, tout traitement thermique, et l'oxydation thermique en fait partie, conduit à une diffusion latérale du canal du transistor pouvant entraîner le phénomène de perçage ou une modification de la tension de seuil.

De plus, l'utilisation d'espaceurs en silicium polycristallin ou en tout autre matériau conducteur pouvant être enlevé, sans affecter la structure sous-jacente, tel que le tungstène ou l'aluminium, implique des changements d'équipements et des procédés généralement utilisés entraînant une augmentation du coût de fabrication des circuits à transistors LDD.

Il est aussi connu par l'article de E. Bassous et T.H. Ning "Self-aligned polysilicon gate MOSFETS with tailored source and drain profiles", IBM Technical Disclosure Bulletin, vol. 22, n° 11, d'avril 1980, p. 5146-5147 de réduire le nombre de masques en utilisant le même masque pour les deux implantations du même type de conductivité. Mais, ce procédé présente encore des inconvénients tels que la consommation de l'oxyde de champ lors de la fabrication des espaceurs en $SiO_2$ ainsi que la réoxydation importante de la grille des transistors.

La présente invention a justement pour objet un nouveau procédé de fabrication d'un circuit intégré comportant au moins un transistor à effet de champ à double implantation, permettant de remédier aux différents inconvénients donnés ci-dessus et en particulier, d'économiser deux niveaux de masquage dans une technologie CMOS avec des transistors LDD, c'est-à-dire que le nombre total de niveaux de masquage est identique à celui d'une technologie CMOS avec des transistors sans double jonction ainsi que d'utiliser les techniques et équipements standards de fabrication.

De façon plus précise, l'invention a pour objet un procédé de fabrication d'un circuit intégré dans un substrat semi-conducteur, comprenant au moins un transistor MIS d'un premier type, à doubles jonctions, formé dans une région du substrat, isolé électriquement par une isolation latérale, caractérisé en ce qu'il comprend les étapes successives suivantes :

a) réalisation de l'isolation latérale et de l'isolant de grille du transistor du premier type,

b) réalisation de la grille du transistor du premier type dans une couche conductrice,

c) dépôt d'une couche de protection sur toute la structure obtenue en b), le matériau de cette couche de protection étant apte à être gravé sélectivement par rapport à l'isolation latérale,

d) réalisation de bandes d'espacement sur les flancs de la grille en un matériau isolant apte à être gravé sélectivement par rapport au matériau de la couche de protection,

e) première implantation d'ions à une dose donnée et d'un premier type de conductivité, pour former les source et drain du transistor du premier type, les bandes d'espacement, la grille et l'isolation latérale servant de masque à cette première implantation,

f) élimination des bandes d'espacement,

g) deuxième implantation d'ions du même type de conductivité que le premier type, à une dose plus faible que celle de la première implantation, pour former les doubles jonctions,

h) élimination de la couche protectrice et recuit de la structure obtenue.

Selon une mise en oeuvre préférée du procédé selon l'invention, le circuit intégré comprenant des composants d'un second type à doubles jonctions, on réalise avant la première implantation, un masque sur la structure obtenue en d) comportant une ouverture en regard de ladite région du substrat et servant à protéger ces composants du second type, ce masque étant éliminé après la deuxième implantation.

On entend par composants d'un second type, par exemple les transistors pMOS (respectivement nMOS) lorsque le transistor MIS du premier est un transistor nMOS (respectivement MOS), en technologie CMOS.

Le fait de réaliser les bandes d'espacement (ou espaceurs) avant la première implantation permet une simplification importante du procédé par réduction du nombre de niveaux de masquage lorsque le circuit comporte plusieurs types de transistors. En particulier, on forme les bandes d'espacement en effectuant un dépôt isotrope d'isolant électrique sur l'ensemble de la structure et en effectuant une gravure anisotrope de ce dépôt. L'utilisation des bandes d'espacement permet d'effectuer les implantations à forte dose et faible dose successivement, sans étape intermédiaire de masquage lithographique.

L'utilisation conformément à l'invention d'une couche protectrice recouvrant toute la structure obtenue en b) (y compris les flancs de la grille), qui peut être gravée sélectivement par rapport à l'isolation électrique latérale servant à l'isolement des transistors, en général de l'oxyde de champ, et par rapport aux bandes d'espacement, permet de protéger cet oxyde de champ, lors de la gravure des bandes d'espacement, et en particulier d'éviter sa consommation lorsque les produits de gravure utilisés pour graver les bandes d'espacement sont aussi aptes à graver cet oxyde de champ ; ceci est en particulier le cas lorsque les bandes d'espacement ont la même composition que l'oxyde de champ.

En outre, cette couche protectrice permet une bonne détection de fin d'attaque de gravure (analyse de raies d'émission du plasma de gravure par exemple) de la couche isolante servant à former les bandes d'espacement. Par ailleurs, elle permet de protéger les zones actives source-drain en fin de gravure (ou formation) des espaceurs (dans l'art antérieur, la gravure des espaceurs s'arrête dans le substrat de silicium) ; elle permet donc de supprimer l'étape de nettoyage utilisée dans l'art antérieur pour éliminer les résidus de gravure des zones actives et supprimer tout risque de contamination à cette étape de gravure.

Cette couche de protection présente en outre l'avantage de conserver un procédé de fabrication standard des circuits intégrés à transistors LDD et en particulier des traitements thermiques et de ne rien changer à l'assemblage technologique de fabrication de ces circuits ni à leur optimisation. Elle permet ainsi une limitation du coût de fabrication de ces circuits.

Selon une mise en oeuvre préférée du procédé selon l'invention, le matériau de la couche protectrice étant conducteur, on recouvre avant le dépôt de la couche de protection, la grille et les régions du substrat dans lesquelles on réalise la source et le drain du transistor, par une couche d'isolation électrique apte à être gravée sélectivement par rapport au substrat, la couche protectrice étant apte à être gravée sélectivement par rapport à la couche d'isolation électrique.

Selon une autre mise en oeuvre du procédé de l'invention, le matériau de la couche protectrice étant isolant et apte à être gravé sélectivement par rapport au substrat, la couche de protection peut être déposée directement sur la structure obtenue en b).

L'invention s'applique aussi bien à un substrat massif en silicium monocristallin dopé de type n ou p qu'à une couche de silicium monocristallin n ou p supportée par un substrat isolant (technologie SSI).

En outre, la grille peut être réalisée en un grand nombre de matériaux comme par exemple le silicium polycristallin ou amorphe dopé, les métaux réfractaires tels que Mo, Ti, Ta, W et leurs siliciures ou un empilement de deux ou plus de ces matériaux. Dans ce dernier cas, la grille peut être composée d'un matériau bicouche silicium polycristallin-siliciure de tungstène (WSi$_2$) ou de tantale (TaSi$_2$).

De même, les isolants électriques peuvent être réalisés en un grand nombre de matériaux tels que l'oxyde de silicium, le nitrure de silicium et l'oxynitrure de silicium.

Par isolation latérale, il faut comprendre aussi bien une isolation de surface du type oxyde de champ qu'une isolation en profondeur par tranchée d'isolement.

De façon préférentielle, le procédé selon l'invention comprend les étapes successives suivantes :

A) réalisation de l'isolation latérale et de l'isolant de grille du transistor du premier type,

B) réalisation de la grille du transistor du premier type dans une couche conductrice en silicium dopé,

C) recouvrement de la grille et des régions du substrat dans lesquelles la source et le drain du transistor du premier type seront réalisés, par une couche d'isolant électrique apte à être gravée sélectivement par rapport au substrat,

D) dépôt, sur la structure obtenue en C, de la couche de protection en un matériau apte à être gravé sélectivement par rapport à l'isolation latérale et à l'isolant formé au cours de l'étape C),

E) réalisation des bandes d'espacement en un matériau isolant apte à être gravé sélectivement par rapport à la couche de protection déposée en D),

F) première implantation d'ions à forte dose des source et drain du transistor du premier type,

G) élimination des bandes d'espacement,

H) deuxième implantation d'ions, à une dose plus faible que celle de la première implantation, pour former les doubles jonctions,

I) élimination de la couche de protection et recuit de la structure obtenue.

Avantageusement, l'invention s'applique au circuit intégré MIS ou MOS utilisant comme substrat du silicium monocristallin dopé n ou p, comme grille du silicium polycristallin dopé n ou p et comme isolant des couches d'oxyde de silicium ou de nitrure de silicium.

Par ailleurs, la couche protectrice peut être réalisée en silicium polycristallin, en nitrure de silicium, en oxynitrure de silicium ou en métal tel que le titane, l'aluminium. En l'absence de couche d'isolant électrique sous la couche de protection, cette dernière est réalisée en un matériau isolant électrique afin d'éviter toute contamination du substrat par un métal et donc une modification non contrôlée de ses propriétés électriques.

Par élimination de la couche protectrice, il faut comprendre son attaque chimique ou sa transformation en une autre couche par réaction chimique (par exemple transformation du silicium en $SiO_2$ ou $Si_3N_4$).

Dans le cas de la grille du transistor réalisée en silicium, l'isolation électrique de cette grille et des zones actives peut être obtenue par oxydation thermique du silicium dénommée ci-après réoxydation. Dans ce cas, la couche de protection permet de résoudre un certain nombre de problèmes.

En effet, cette couche de protection permet de limiter l'épaisseur de réoxydation de la grille et des zones actives du substrat au minimum nécessaire ($\leq$ 30 nm sur les zones actives) puisque cet oxyde n'est pas attaqué lors de la formation des espaceurs. Ceci est particulièrement intéressant dans le cas des technologies submicroniques (500 à 1000 nm de longueur de grille), où les transistors à double implantation sont utilisés et rendus nécessaires, la réoxydation devant être limitée pour minimiser le "budget" thermique des implantations ioniques de canal effectuées auparavant dans l'assemblage technologique.

Par ailleurs, dans le cas de grilles de transistors composées d'un bicouche silicium polycristallin-siliciure (ce qui est généralement le cas dans les technologies submicroniques), cette étape de réoxydation entraîne également une augmentation (avec l'épaisseur de l'oxydation) de la résistance carrée de la grille de ces transistors, d'où une perte de vitesse de fonctionnement.

D'autres caractéristiques et avantages de l'invention ressortiront mieux de la description qui va suivre, donnée à titre illustratif et non limitatif.

La description est faite en référence aux figures annexées dans lesquelles :

- les figures 1a-1g, déjà décrites, représentent schématiquement, en coupe longitudinale, les différentes étapes de fabrication, selon l'art antérieur, d'un circuit intégré comportant un transistor à effet de champ à double implantation, et

- les figures 2a-2g représentent schématiquement, en coupe longitudinale, les différentes étapes de fabrication, selon l'invention, d'un circuit intégré comportant un transistor à effet de champ à double implantation.

La description qui suit se rapporte à la fabrication d'un transistor à effet de champ MOS à double implantation, à canal n, dans un substrat en silicium de type p. Mais bien entendu, comme on l'a dit précédemment, l'invention est d'application beaucoup plus générale. En particulier, l'invention s'applique à un transistor à canal p formé dans un substrat en silicium de type n, à la fabrication de circuits CMOS comportant des transistors à canal n et des transistors à canal p intégrés sur un même substrat ainsi qu'à des circuits BICMOS comportant en outre des transistors bipolaires.

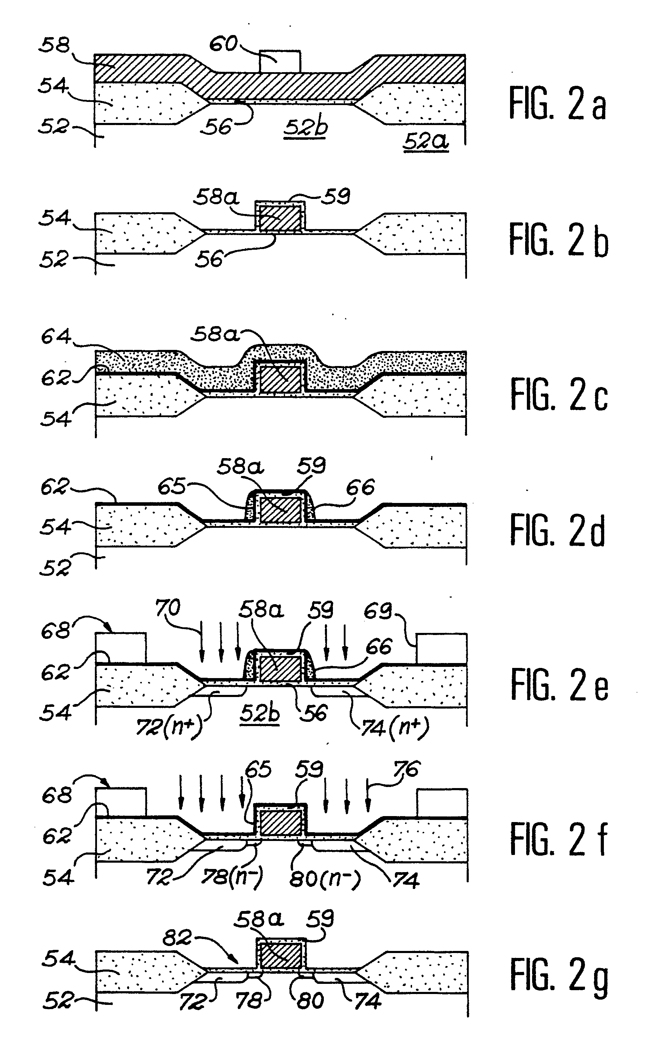

Comme pour le procédé de l'art antérieur, décrit précédemment, on forme tout d'abord sur un substrat en silicium monocristallin 52 de type p, représenté sur la figure 2a, un oxyde de champ 54, par oxydation localisée du substrat 52, en particulier par la technique LOCOS bien connue de l'homme de l'art. Cet oxyde de champ 54 sert à isoler électriquement les différents composants actifs du circuit intégré. Il présente une épaisseur de 600 nm environ.

La région du substrat dans laquelle est formé l'oxyde de champ porte la référence 52a et la région dans laquelle sera formé le transistor MOS porte la référence 52b. Les régions 52a et 52b sont juxtaposées.

Après formation de l'oxyde de champ 54, on forme dans la région 52b du substrat une mince couche d'oxyde de silicium 56, qui servira d'oxyde de grille du transistor. Cet oxyde de grille est obtenu par oxydation thermique de la région 52b du substrat, à une température de l'ordre de 950°C, pendant 20 min environ. Il présente une épaisseur de 20 nm environ.

On dépose ensuite sur l'ensemble de la structure une couche conductrice 58 notamment en silicium polycristallin dopé avec des dopants de conductivité inverse de celle du substrat. Cette couche conductrice 58 dopée n est obtenue par exemple par le dépôt chimique en phase vapeur à basse température (615° C) de silicium polycristallin intrinsèque, par pyrolyse de SiH₄, suivi d'une étape de dopage du silicium au four par du POCl₃ à 900° C. Cette couche 58 présente une épaisseur de 400 nm environ.

On forme ensuite sur la couche de silicium 58, par photolithographie, un masque de résine positive 60 représentant l'image de la grille du transistor à réaliser dans la couche 58, c'est-à-dire masquant la région de la couche conductrice 58 qui servira de grille.

On effectue alors, comme représenté sur la figure 2b, une gravure de la couche 58 afin de former la grille 58a du transistor en utilisant la résine 60 comme masque à cette gravure. L'élimination des régions de la couche 58 non recouvertes de résine peut être réalisée par une gravure ionique réactive en utilisant un plasma d'hexafluorure de soufre ou tout autre gravure par plasma ayant des caractéristiques d'anisotropie élevée. La grille 58a obtenue présente généralement une largeur l de moins de 2 micromètres.

Après élimination du masque de résine 60 avec un plasma d'oxygène isotrope, on forme une isolation électrique 59 sur la grille 58a du transistor et sur les régions du substrat dans lesquelles seront formés respectivement les source et drain du transistor. Cette isolation électrique 59 est réalisée par réoxydation thermique du silicium constituant la grille 58a et le substrat 52. Cette réoxydation peut être réalisée à 900° C pendant 20 min environ ; elle présente une épaisseur de 10 à 20 nm environ sur le substrat et de 20 nm environ sur la grille.

L'étape suivante du procédé consiste, comme représenté sur la figure 2c, à déposer sur l'ensemble de la structure une couche mince protectrice 62 qui doit être gravée sélectivement par rapport à l'isolant 59 et à l'oxyde de champ 54. Cette couche 62 présente une épaisseur de 30 à 50 nm et est réalisée de préférence en silicium polycristallin éventuellement dopé de type n. Cette couche 62 est obtenue par le dépôt chimique en phase vapeur à basse pression (LPCVD) de silicium, par pyrolyse du silane à une température de 615° C environ, suivi éventuellement d'une étape de dopage par du POCl₃ à 900° C.

On dépose ensuite sur toute la couche 62 une couche isolante 64 destinée à être gravée sélectivement par rapport à la couche 62. Cette couche 64 est de préférence une couche d'oxyde de silicium de 400 nm d'épaisseur environ. Cette couche 64 est déposée par la technique de dépôt chimique en phase vapeur basse pression (LPCVD), par pyrolyse de tétraéthylorthosilicate (TEOS) à 800° C.

On effectue ensuite la gravure anisotrope de la couche d'oxyde de silicium 64, la couche de silicium 62 servant de couche d'arrêt de gravure.

Cette gravure est une gravure pleine plaque. Elle peut être réalisée en mode ionique réactif en utilisant comme agent de gravure un plasma de tri- ou tétrafluorométhane .ou par tout autre procédé de gravure sèche anisotropique. On obtient ainsi, sur les flancs protégés 65 de la grille 58a du transistor, des bandes ou liserés d'oxyde 66 jouant le rôle d'espaceurs. la structure obtenue est représentée sur la figure 2d.

Ces espaceurs 66 sont des résidus volontaires qui résultent des surépaisseurs d'oxyde de silicium sur les flancs 65 des motifs de grille.

L'étape suivante du procédé, comme représenté sur la figure 2e, consiste à former un nouveau masque de résine 68 permettant de définir l'emplacement de la source et du drain du transistor à réaliser. En particulier, ce masque 68, réalisé par les techniques classiques de photolithographie (photorépétition directe sur tranche), comporte une ouverture 69 en regard de la région 52b du substrat dans laquelle sera réalisé le transistor.

On effectue alors une première implantation ionique 70 à forte dose par exemple d'ions d'arsenic à une dose de $5 \times 10^{15}$ ions/cm² avec une énergie de 80keV. Cette implantation ionique 70 permet de former, de part et d'autre des espaceurs 66, deux régions respectivement 72 et 74 de type n⁺ correspondant respectivement à la source et au drain du transistor. La source 72 et le drain 74 présentent une épaisseur de l'ordre de 350 nm.

L'implantation ionique 70 est réalisée en utilisant la résine 68, l'isolation latérale 54, les espaceurs 66 et la grille 58a du transistor revêtue de l'isolation 59 et de la couche de protection 62 comme masque. Les espaceurs permettent d'éviter l'extension des régions 72 et 74 sous le canal du transistor (c'est-à-dire sous la grille 58a). Cette implantation ionique 70 est donc autopositionnée par rapport aux espaceurs 66 entourant la grille 58a.

On effectue ensuite l'élimination des espaceurs 66 par gravure chimique dans un bain de FH-FNH₄ ou par tout autre procédé, sec ou humide, isotropique, sélectif par rapport à la couche protectrice de silicium polycristallin 62 et par rapport à la résine de masquage 68. Cette opération de gravure n'est pas critique puisque le circuit intégré est protégé par la fine couche de silicium 62. La structure obtenue est alors représentée sur la figure 2f.

Toujours à l'aide du masque 68, on réalise alors une seconde implantation d'ions 76 à faible dose de phosphore servant à former deux régions 78 et 80 à proximité respectivement des zones actives 72 et 74 et des flancs isolés 65 de la grille 58a, réalisant ainsi les doubles jonctions du transistor. Cette seconde implantation est autopositionnée par rapport à la première implantation. Les regions 78 et 80 présentent la même conductivité que les régions 72 et 74 mais n⁻.

L'implantation d'ions de phosphore 76 peut être réalisée à une dose de l'ordre de $2 \times 10^{13}$ ions/cm² et à une énergie de 80keV ; ceci permet la pénétration des ions phosphore dans le substrat jusqu'à une profondeur de l'ordre de 200 nm.

L'étape suivante du procédé selon l'invention consiste à éliminer le masque de résine 68 à l'aide d'un plasma d'oxygène isotrope puis à éliminer la couche de silicium polycristallin 62. Cette élimination consiste à soumettre la structure obtenue à un plasma d'hexafluorure de soufre.

Après cette élimination, on effectue alors un recuit de la structure afin de permettre une diffusion des ions implantés ainsi qu'une guérison des défauts créés lors des implantations. Ce recuit peut être réalisé à une température de 900°C pendant quelques dizaines de minutes (30 min), sous atmosphère d'azote. La structure est alors celle représentée sur la figure 2g. Le transistor réalisé porte la référence 82.

Au lieu d'éliminer la couche de silicium par attaque plasma, il est possible de l'oxyder thermiquement par exemple à 900°C en présence d'oxygène pendant 30 min. Cette oxydation thermique permet alors d'éviter le recuit d'implantation.

Une couche isolante dopée (phosphore PSG ou bore et phosphore BPSG) est ensuite déposée, fluée et gravée avec la couche 59 et la couche de protection, lorsque cette dernière est oxydée, afin de former les différents trous de contact électrique. On dépose ensuite sur cette couche isolante une couche conductrice généralement en aluminium que l'on grave afin de former les différentes connexions du circuit intégré.

La description donnée ci-dessus n'a bien entendu été donnée qu'à titre illustratif, toute modification, sans pour autant sortir du cadre de l'invention, peut être envisagée notamment en ce qui concerne la nature des couches, leur épaisseur, leur technique de dépôt et de gravure.

Dans le cadre de la réalisation d'un circuit CMOS, on effectue successivement les implantations du type n destinées à la fabrication des transistors nMOS et les implantations du type p destinées à la fabrication des transistors pMOS. Dans ce dernier cas, la première implantation à forte dose (figure 2e) est réalisée avec des ions de $BF_2$ à une dose de $4 \times 10^{15}$ ions/cm² et une énergie de 45keV et la seconde implantation à faible dose (figure 2f) est réalisée aussi avec du $BF_2$ mais à une dose de $2 \times 10^{13}$ ions/cm² et une énergie de 40keV. Ces deux implantations successives sont réalisées à travers un masque d'implantation équipé d'ouvertures en regard des régions du substrat dans lesquelles on forme les transistors pMOS, les régions destinées aux transistors nMOS étant protégées de l'implantation de type p.

De même, le masque 68 comporte des ouvertures en regard des régions 52b destinées aux transistors nMOS et masque les régions destinées aux transistors pMOS.

Le procédé selon l'invention grâce à un enchaînement d'étapes particulier permet de réduire le nombre de ses étapes et en particulier, le nombre d'étapes de masquage tout en conservant une technologie classique de réalisation des transistors LDD. Ceci est principalement lié à la réalisation des espaceurs en $SiO_2$, situés de part et d'autre de la grille du transistor à effet de champ, avant d'effectuer les deux implantations ioniques nécessaires pour former la source et le drain du transistor et à la réalisation de l'implantation forte dose avant celle de l'implantation faible dose.

Ceci permet en outre la réalisation des deux dopages successifs du substrat pour former les doubles jonctions du transistor à l'aide du même masque de résine.

**Revendications**

1. Procédé de fabrication d'un circuit intégré dans un substrat semi-conducteur comprenant au moins un transistor MIS (82) d'un premier type, à deux doubles jonctions, formé dans une région (52b) du substrat, isolé électriquement par une isolation latérale (54), caractérisé en ce qu'il comprend les étapes suivantes :

a) réalisation de l'isolation latérale (54) et de l'isolant de grille (56) du transistor (82) du premier type,

b) réalisation de la grille (58a) du transistor du premier type dans une couche conductrice (58),

c) dépôt d'une couche de protection (62) sur toute la structure obtenue en b), le matériau de cette couche de protection étant apte à être gravé sélectivement par rapport à l'isolation latérale (54),

d) réalisation de bandes d'espacement (66) sur les flancs (65) de la grille (58a) en un matériau isolant apte à être gravé sélectivement par rapport au matériau de la couche de protection,

e) première implantation d'ions (70) à une dose donnée et d'un premier type de conductivité, pour former les source et drain (72, 74) du transistor du premier type, les bandes d'espacement (66), la grille (56) et l'isolation latérale servant de masque à cette première implantation,

f) élimination des bandes d'espacement (66),

g) deuxième implantation d'ions (76) du même type de conductivité que le premier type, à une dose plus faible que celle de la première implantation, pour former les doubles jonctions (78, 80),

h) élimination de la couche protectrice (62) et recuit de la structure obtenue.

2. Procédé selon la revendication 1, carac térisé en ce que la couche de protection étant conductrice, on recouvre avant le dépôt de cette couche de protection (62), la grille (56) et les régions du substrat dans lesquelles on réalise la source et le drain du transistor, par une couche d'isolation électrique (59) apte à être gravée sélectivement par rapport au substrat, la couche de protection étant apte à être gravée sélectivement par rapport à la couche d'isolation électrique.

3. Procédé selon la revendication 1, caractérisé en ce que la couche de protection étant isolante et apte à être gravée sélectivement par rapport au substrat, la couche de protection (62) est déposée directement sur la structure obtenue en b).

4. Procédé selon l'une quelconque des revendications 1 à 3, caractérisé en ce que les bandes d'espacement (66) sont en oxyde de silicium.

5. Procédé selon l'une quelconque des revendications 1 à 4, caractérisé en ce que la couche de protection (62) est réalisée en silicium polycristallin.

6. Procédé selon l'une quelconque des revendications 1 à 5, caractérisé en ce que le substrat (52) est en silicium.

7. Procédé selon l'une quelconque des revendications 1 à 6 de fabrication d'un circuit intégré ·dans un substrat en silicium dopé, comprenant les étapes successives suivantes :

A) réalisation de l'isolation latérale (54) et de l'isolant de grille (56) du transistor du premier type,

B) réalisation de la grille (58a) du transistor du premier type dans une couche conductrice en silicium dopé,

C) recouvrement de la grille (58a) et des régions du substrat dans lesquelles la source et le drain du transistor du premier type seront réalisés, par une couche d'isolant électrique (59) apte à être gravée sélectivement par rapport au substrat,

D) dépôt, sur la structure obtenue en C, de la couche de protection (62) en un matériau apte à être gravé sélectivement par rapport à l'isolation latérale (54) et à l'isolant (59) formé au cours de l'étape C),

E) réalisation des bandes d'espacement (66) en un matériau isolant apte à être gravé sélectivement par rapport à la couche de protection déposée en D),

F) première implantation d'ions (70) à forte dose des source et drain (72, 74) du transistor du premier type,

G) élimination des bandes d'espacement (66),

H) deuxième implantation d'ions (76), à une dose plus faible que celle de la première implantation, pour former les doubles jonctions (78, 80),

I) élimination de la couche de protection (62) et recuit de la structure obtenue.

8. Procédé selon l'une quelconque des revendications 1 à 7 de fabrication d'un circuit intégré comprenant en outre des transistors d'un second type à doubles jonctions, caractérisé en ce que l'on réalise avant la première implantation, un masque (68) sur la structure obtenue en d) comportant une ouverture (69) en regard de la région (52b) du substrat dans laquelle est formé le transistor du premier type et servant à protéger ces composants du second type, ce masque étant éliminé-après la deuxième implantation.

9. Procédé selon la revendication 7, caractérisé en ce que l'étape C est réalisée par oxydation thermique de la grille (58a) et desdites régions du substrat.

10. Procédé selon la revendication 9, caractérisé en ce que l'oxyde (59) formé sur les régions source et drain au cours de l'étape C a une épaisseur d'au plus 30 nm.

11. Procédé selon l'une quelconque des revendications précédentes, caractérisé en ce que l'isolant de grille (56) est de l'oxyde de silicium.

12. Procédé selon l'une quelconque des revendications précédentes, caractérisé en ce que l'on forme les bandes d'espacement (66) en effectuant un dépôt isotrope (64) d'un matériau isolant sur l'ensemble de la structure et en effectuant une gravure anisotrope de ce dépôt.

FIG. 1 a

FIG. 1 b

FIG. 1 c

FIG. 1 d

FIG. 1 e

FIG. 1 f

FIG. 1 g

FIG. 2 a

FIG. 2 b

FIG. 2 c

FIG. 2 d

FIG. 2 e

FIG. 2 f

FIG. 2 g

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,A | US-A-4 753 898 (L.C. PARRILLO et al.) <br> * Revendications 1-14 * <br> --- | 1,7 | H 01 L 21/336 <br> H 01 L 21/28 <br> H 01 L 21/82 <br> H 01 L 29/784 |
| A | EP-A-0 216 052 (MOTOROLA INC.) <br> * Revendication 1 * <br> --- | 1,7 | |
| A | EP-A-0 216 053 (MOTOROLA INC.) <br> * Revendications 1-10 * <br> --- | 1,7 | |
| A | US-A-4 011 576 (Y. UCHIDA et al.) <br> --- | | |
| A | EP-A-0 244 607 (SIEMENS AG) <br> ----- | | |

**DOMAINES TECHNIQUES RECHERCHES (Int. Cl.5)**

H 01 L

Le présent rapport a été établi pour toutes les revendications

| Lieu de la recherche | Date d'achèvement de la recherche | Examinateur |
|---|---|---|
| LA HAYE | 20-07-1990 | ZOLLFRANK G.O. |